Europäisches Patentamt

European Patent Office

Office européen des brevets

(19)

(11) Publication number: **0 120 819**
**A2**

(12) **EUROPEAN PATENT APPLICATION**

(21) Application number: **84830077.8**

(22) Date of filing: **16.03.84**

(51) Int. Cl.³: **G 11 C 17/00**

(30) Priority: **23.03.83 IT 121283 U**

(43) Date of publication of application:
**03.10.84 Bulletin 84/40**

(84) Designated Contracting States:
**BE CH DE FR GB LI NL**

(71) Applicant: **Bruni, Lucia**
**Località Giovi n. 161**
**I-52100 Arezzo(IT)**

(72) Inventor: **Bruni, Lucia**
**Località Giovi n. 161**
**I-52100 Arezzo(IT)**

(74) Representative: **Mannucci, Gianfranco, Dott.-Ing.**
**Ufficio Tecnico Ing. A. Mannucci Via della Scala 4**
**I-50123 Firenze(IT)**

(54) Circuit controlling the erasure of electronic storages.

(57) An electronic circuit, applied to apparatuses for the erasure of storages by means of ultraviolet rays lamps, comprises a photoresistor which is wrapped in an ultraviolet rays-sensitive film, so that it has an electric conductivity depending only on the intensity of the ultraviolet rays emitted by the lamp; therefore, the quantity of current passing through it, being measured by an integrating circuit, once reached the value programmed by the operator, causes the operation of a relay cutting off the lamp power supply.

Fig.1

EP 0 120 819 A2

CIRCUIT CONTROLLING THE ERASURE OF ELECTRONIC STORAGES.
LUCIA BRUNI in Arezzo (Italy).

The invention regards an electronic circuit which, when applied to apparatuses for the erasure of electronic storages (memories) will cut off the ultraviolet rays lamp supply when the storages to be erased have been exposed to a programmed quantity of rays.

At present, the electronic storages which must be erased of their information content, are exposed to the ultraviolet rays emitted by a lamp, for a period of time predetermined in an approximate way.

The duration of said period depends – besides on the type of storages to be erased – on the intensity of the rays emitted by the lamp.

Accordingly, as a rule, said duration is determined empirically and the operators conform – for safety's sake – to values in excess thus preventing an imperfect erasure verifiable from the reading of the information contents of the storages being subjected to erasure.

When the erasure operation takes place in a repetitive way, the over-exposure of the storage or memory M to ultraviolet rays brings about only a waist of time, therefore, it would be an advantage the presence of a detector able to check with precision if the erasure has taken place so to allow the operator to replace at the right moment the erased storages with others which have to be erased.

The circuit of the present patent permits to overcome the present approximation and empiricism of the erasure procedures by filling in the above mentioned gap.

Substantially, the present circuit comprises a photoresistance which will be laid on the plane on which the storages are laid to be exposed to the ultraviolet rays emitted by a suitable lamp in order to be erased. A suitable screen, acting as a filter, wraps the photosensitive element to allow the effect of the sole ultraviolet rays emitted by the lamp in order to make directly proportional between each other the intensity of these rays and the photoresistor conductivity or other equivalent element.

The quantity of current which goes through the photosensitive element (usually a photoresistor) will be therefore a function of the exposure time and of the intensity of the ultraviolet rays emitted by the lamp which, besides striking the photoresistor, will also strike the storages to be erased.

An integrator, programmable by the operator so as to adapt the circuit of the invention to the type of storages to be erased, measures the quantity of current which has passed through the photoresistor and, once reached the programmed value, actuates a relay which cuts off the lamp supply to allow then the timely replacement of the erased storages with others which must still be subjected to such an operation.

The present invention is illustrated by way of exemplification in the accompanying table.

Fig. 1 shows a block diagram; and

Fig. 2 shows in section a photosensitive element according to the invention.

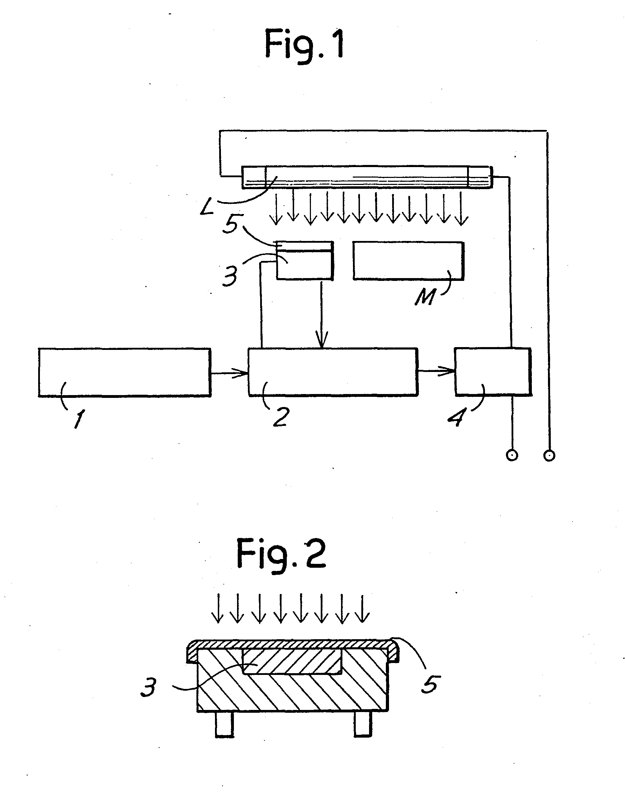

In Fig. 1, 1 indicates the supply unit which can supply as well other circuits of the apparatus to which the invention is applied; 2 indicates the integrating circuit to which the photosensitive element 3 (usually made up of a photoresistance) is applied. The photosensitive element 3 is made sensitive only to the ultraviolet rays by means of a screening 5 made up, for example, of a fluorescent film able to act as a filter and permitting therefore only the ultraviolet rays to come into action among all the others emitted by the lamp; only these rays excite the filter layer 5, which at its turn influences the photosensitive element. The integrating circuit 2 is programmed by the operator to actuate the relay 4, or other element capable of cutting off the circuit 7 of power supply to the ultraviolet rays lamp L when the quantity of the current which has passed through the element 3 reaches the desired value.

The present invention, therefore, permits to automatically change the exposure time of the storages M to be erased when, for any reason, changes take place in the emission of rays from the lamp, allowing to check the storages efficiency level as well.

## CLAIMS

1) A control circuit for the erasure of electronic storages by means of an ultraviolet rays lamp characterized by a photosensitive element (3), which will be energized only by the ultraviolet rays emitted by the lamp (L), and by an integrating circuit (2) which operates the interruption of the power supply to the ultraviolet rays lamp (L) when a programmed quantity of current has flowed through the photosensitive element (3).

2) A control circuit for the erasure of electronic storages according to claim 1, characterized in that the photosensitive element (3) is screened by a surface (5) which can be activated by the ultraviolet rays only.

3) A control circuit for the erasure of electronic storages according to claim 2, characterized in that the photosensitive element (3) as a whole is struck by the rays emitted by the ultraviolet rays lamp (L) like the storages (M) to be erased, which element may be coplanar with said storages.

4) A control circuit for the erasure of electronic storages according to claim 1, characterized by an integrating unit (2) capable of measuring the quantity of current which has flowed through the photosensitive element (3, 5).

5) A control circuit for the erasure of electronic storages according to claim 4, characterized in that the integrating unit (2) can be programmed in order to be programmed by the operator so as to adapt it to the requirements of different types of storages to be erased.

6) A control circuit for the erasure of electronic storages according to claim 1, characterized in that the integrating unit (2) operates a circuit (7) able to cut off the power supply to the ultraviolet rays lamp (L).

7) A control circuit for the erasure of electronic storages according to claim 6, characterized in that the circuit (7) controlled by the integrating unit (2) in order to cut off the power supply to the lamp (L) comprises a relay.

## Fig.1

## Fig.2